# EUROPEAN PATENT APPLICATION

(11) **EP 4 741 843 A1**
(43) Date of publication of application: **13.05.2026**
(21) Application number: 25212334.4
(22) Date of filing: 30.10.2025
(51) Int. Cl.: G01R 31/12, G01R 29/24

(54) **INTEGRATED SPACE CHARGE MONITORING FOR HIGH VOLTAGE CABLES**

(30) Priority: 08.11.2024 NO 20241109
(71) Applicant: Nexans, 92400 Courbevoie (FR)
(72) Inventor: Doedens, Espen, 1788 Halden (NO); Singh, Birender, 1788 Halden (NO); Frisk, Nils-Bertil, 45297 Strömstad (SE)
(74) Representative: Acapo Onsagers AS

(57) **Abstract**

There is provided apparatus for enabling space charge distribution measurement of a high voltage cable (110). The apparatus comprises: a compartment (140; 240; 340; 440) for holding a pulsed electro-acoustic, PEA, sensor (260; 360) in contact with the high voltage cable; and a coupling structure (130; 230; 330; 424; 529) configured to couple the compartment to the high voltage cable between a base of a termination device (120; 420) of the high voltage cable and a ground screen (150; 450) of the high voltage cable.

## Description

### FIELD OF THE INVENTION

Aspects relate to systems and methods for apparatus, systems and methods for enabling space charge distribution measurement of a high voltage cable, and to methods of maintaining systems for space charge distribution measurement of a high voltage cable.

### BACKGROUND

High voltage cables, particularly high voltage direct current, HVDC, cables are used in electrical power distribution or transmission systems. Such power cables generally comprise a central part or core made of conductive material, layers of insulating material and protective layers including a metallic water barrier. Some of the layers of insulating may comprise materials whose function is to control the electrical field around the central part of the cable.

Some electrically insulating materials used in these layers, such as the dielectric insulation, can exhibit conductivity gradients and charge carrier traps which give rise to a space charge and a non-uniform distribution of the electrical field. Non-uniform distribution of the electrical field can cause high concentrations of the electrical field in parts of the cable. Such high concentrations may cause the electrical insulation of the cable to age prematurely and ultimately break down.

The measurement of the spatial location of these charges makes it possible to determine the charge accumulation mechanisms and avoid such a rupturing of insulation. It is also an indicator of the state of health of the cable.

There are acoustic techniques for measuring spatial distribution of space charges, in which an acoustic pulse is excited and is propagated in a sample being studied. One of these acoustic techniques is known as the pulsed electro-acoustic, or PEA, technique. In the PEA technique, a PEA sensor, which incorporates an acoustic transducer, such as a piezoelectric transducer or a pressure transducer or pressure sensor, is provided in contact with a semiconductive or dielectric material. The PEA sensor measures oscillations or vibrations resulting from excitation of the space charges in the material when an electrical field pulse is applied.

Traditionally, the PEA technique was applied in a dedicated "measurement cell" and samples of material were tested. Recently, it is becoming common to perform the PEA method on operational high voltage cables. In such methods, a short portion of the cable is selected along its length and sensing apparatus is applied. The protective, outer layers of the cable have poor acoustic properties that prevent the PEA method being accurately performed, so to apply the sensing apparatus, the outer semiconductive layer are first accessed through the protective layers by stripping back the cable. Stripping back the cable requires significant modification to the cable, and for relatively large sensing apparatus to be attached to the cable. Moreover, the cable then has to be re-sealed with the apparatus attached, so as to prevent water ingress. Other difficulties may be encountered, such as chemical residue outgassing, which may hamper efforts to obtain good quality measurements. Altogether, this results in an arduous and cumbersome process, as well as one that may potentially result in water ingress or poor measurements.

### SUMMARY OF THE INVENTION

The present invention is defined by the appended claims and in the following:
According to a first aspect, there is provided an apparatus for enabling space charge distribution measurement of a high voltage cable. The apparatus comprises: a compartment for holding a pulsed electro-acoustic, PEA, sensor in contact with the high voltage cable; and a coupling structure configured to couple the compartment to the high voltage cable between a base of a termination device of the high voltage cable and a ground screen of the high voltage cable.

The apparatus provides a way of mounting a PEA sensor to a high voltage cable to enable accessible and convenient space charge distribution measurement. The part of the cable between the base of the termination device and the ground screen is a part that lacks protective layers, as this would ordinarily be protected and covered by other components, such as cable glands. Providing apparatus to connect a PEA sensor to this part of the cable therefore enables an efficient way of integrating space charge distribution measurement.

Furthermore, the termination and ground screen are conveniently located, meaning that the apparatus will be accessible for installation of the PEA sensor and maintenance, and for connection of equipment for monitoring and providing pulses. This is especially useful for undersea cables, where locations other than the termination may be difficult to access. Additionally, other solutions, which integrate PEA sensors elsewhere may require dedicated sensing equipment, which may be difficult to locate.

The compartment may be sealed against the cable or may be sealable against the cable. The compartment may be sealed against the cable, at least in part, by the coupling structure. The coupling structure may be configured to seal the high voltage cable to prevent water ingress. The coupling structure may seal against the high voltage cable. The coupling structure may seal against the termination device and/or against the ground screen. The compartment may be integrally formed with the coupling structure, such that the coupling structure sealing the cable also seals the compartment.

The compartment may have or may define an internal volume in which at least part of the PEA sensor is held, in use. The compartment may be configured to maintain a position of the PEA sensor within the internal volume, in use. The compartment may have, define, or delimit an aperture that, when the apparatus is mounted, faces the cable and provides access to the cable for the PEA sensor to be in contact with it. When placed in the compartment, the PEA sensor may reside partially within the internal volume, and part of the PEA sensor, including at least a contacting portion of the PEA sensor formed from, e.g., acoustic glass, extending through the aperture to come into contact with the cable. The apparatus may be configured to couple the compartment to the high voltage cable such that the internal volume of the compartment is connected to a volume around the cable through the aperture.

The coupling structure may be configured to couple the compartment to the termination and/or the ground screen in addition to the high voltage cable. The coupling structure maybe configured to extend between the base of the termination and the ground screen.

The apparatus may be at least partially formed from existing cable infrastructure. For example, the coupling structure may be or may be partially formed by part of the termination device, part of the ground screen, or another component that connects to the cable between the termination device and the ground screen. Alternatively, the apparatus may be provided as an additional component for positioning between existing cable infrastructure.

The coupling structure may comprise a cable gland. Integrating the compartment with the cable gland enables a sealed or sealable structure that connects to the cable beneath the termination to be used for PEA sensing. Cable glands are present beneath terminations in use ordinarily, so such integration enables the cable gland to effectively perform two functions. This dual use may result in improved measurements of space charge distribution, because of the location of the cable gland and because the cable gland is configured to surround an outer semiconductive layer of the cable.

The cable gland may include a housing, and the compartment may be welded or otherwise fixed to the housing. This may result in straightforward manufacture of the apparatus.

The cable gland may include an aperture for allowing access between the compartment and the cable. The aperture may align with an aperture of the compartment. The compartment may be mounted to the cable gland or integrated with it in a region without additional insulative layers between a housing of the cable gland and the cable.

The coupling structure may comprise a base plate of the termination device. The base plate of the termination device also provides a stable and sealable structure with which a compartment for PEA sensing can be integrated. This may enable the compartment to be integrated into the termination device during manufacture, or for the compartment to be hung from or suspended from the base plate, thereby providing stability for the compartment.

In use, the apparatus may overlap with or be sealed against a cable gland.

The coupling structure may comprise a cable clamp. A cable clamp also provides a useful structure for coupling the compartment to the cable. The cable clamp may be configured to be positioned between a cable gland and a base of the termination device, in use. Alternatively, the cable clamp may be configured to be positioned between a cable gland and the ground screen, in use.

The coupling structure may comprise a cable covering, which may otherwise be referred to as a cable tube or intermediate tube. The cable covering may be configured to be positioned between the base of the termination device and the cable gland, in use.

Alternatively, the cable clamp may be configured to be positioned between a cable gland and the ground screen, in use.

An interior of the compartment may be accessible from an exterior of the compartment without removal of the coupling structure from the high voltage cable. Accessibility may be useful to enable maintenance and/or for separate installation of the apparatus and a PEA sensor. During sensing, it may be useful to be able to access the compartment to change or repair the PEA sensor or other systems within the cable. Furthermore, enabling access to the cable may also enable access to the cable, due to the interior of the compartment being connected to a volume surrounding or adjacent the cable, and thus improved maintenance of the cable or devices attached to the cable, such as electrodes, may be achieved.

Additionally, during assembly, it may be desirable to mount the PEA sensor separately from the apparatus due to soldering, welding, or other high-temperature operations that may be required to seal the apparatus against the cable and/or to couple the apparatus to the cable or other components. PEA sensors may be sensitive to high temperatures, so enabling the PEA sensor to be installed after the soldering or other operations may be beneficial for protecting the PEA sensor and enabling high quality measurements.

The compartment may have an opening through which the PEA sensor is received, in use, and a closure for closing the opening. The closure may be configured to connect to or form part of the PEA sensor. The closure may comprise a lid or hatch. The closure may seal the opening. The closure may be sealable against a main body of the compartment. The closure may be connected to the compartment, such as by a hinge or other attachment mechanism, or may be detachable. The compartment and closure may be formed to interconnect, such as by the compartment having grooves into which the closure slides, for example.

The opening may be provided on an exterior of the compartment, and may permit access to the interior of the compartment.

The closure may be connected to a base or side of the PEA sensor, so that placing the closure on the opening to seal the compartment also provides the PEA sensor in a correct orientation and position within the compartment for performing sensing. The closure may incorporate one or more mechanisms for orienting or positioning the PEA sensor in a desired orientation or position. For example, the closure may incorporate a spring or spring mechanism as described below. The closure may form part of the PEA sensor in use, such that a base or side plate forming a body of the PEA sensor is the closure. In other words, the PEA sensor may be manufactured with the closure already integrated. Accordingly, there may be an aspect provided comprising a PEA sensor having transducer, an acoustic glass probe, and a main body housing the transducer and to which the probe is attached, wherein at least a part of the main body comprises a closure for a compartment of an apparatus for holding the PEA sensor in contact with the high voltage cable, in use.

The closure may incorporate one or more bushings or sealable electrical connectors for connecting at least the PEA sensor to processing equipment. The closure may also incorporate bushings or sealable electrical connectors for connecting electrodes provided around the cable to a pulse generator.

The compartment may comprise a spring for holding the PEA sensor in contact with the high voltage cable. The spring, which may be referred to as a spring mechanism or a biasing mechanism, may ensure correct or improved positioning of the PEA sensor relative to the cable and suitable contact to ensure that the measurements are good quality. A spring or spring mechanism may also enable some movement of the PEA sensor as the cable expands or contracts, and may ensure that the contact between the two is maintained during such expansion or contraction.

The spring may be connected at one end to the compartment and at another to the PEA sensor. The spring may be connected to a main body of the PEA sensor on a side that is opposite to the transducer and acoustic glass of the sensor. The spring may act along a radial axis of the cable, with the PEA sensor being urged radially inwardly toward the cable, so that such pressure is maintained. The spring may therefore be connected to a surface of the compartment that is parallel or substantially parallel with a longitudinal axis of the cable.

The compartment may comprise at least one cable bushing that extends through a wall of the compartment. Providing cable bushings may enable electrical connections to be made with external processing equipment without compromising a seal, as the cable bushing enables a sealed electrical connection.

A first cable bushing may be for connecting the PEA sensor to processing equipment, such as a processor. A second cable bushing may be for connecting one or more electrodes to a pulse generator.

The apparatus may comprise a holder for holding a thermal sensor. The coupling structure may be configured to couple the holder to the high voltage cable between the base of the termination device and the ground screen. The holder may be provided within the compartment, such that the thermal sensor is received into the compartment with the PEA sensor. The compartment may comprise one or more cable bushings for providing an electrical connection or another connection, such as an optical connection, to the thermal sensor.

Providing a thermal sensor enables measurement of a local thermal distribution in the region of the PEA sensor. This may be useful to improving the precision and accuracy of the measurements of the PEA sensor which may be adjusted for variations in temperature. Thermal readings from thermal sensors located at other parts of the cable may be used, or modelling may be used, but these readings may not be as accurate.

The thermal sensor may be an optical cable or a contact probe. The holder may hold the thermal sensor in a fixed position relative to the PEA sensor. The holder may enable movement of the thermal sensor relative to the cable, to account for expansion and contraction of the cable.

According to a second aspect, there is provided a system comprising an apparatus as described above and a PEA sensor housed within the compartment of the apparatus.

The PEA sensor may be fixed within the compartment. The PEA sensor may be removeable from the compartment.

The system may further comprise a thermal sensor for measuring a temperature of the high voltage cable between the base of the termination device and the ground screen. The thermal sensor may be fixed relative to the PEA sensor.

The system may further comprise one or more electrodes for delivering an electrical pulse to the high voltage cable.

The electrodes may enable space charges to be excited, thereby causing vibrations. The electrodes may be connectable to a pulse generator. Alternatively, pulses may be caused by other means positioned elsewhere along the cable, such as by using a capacitor coupled to the cable above the termination.

According to a third aspect, there is provided an assembly comprising a high-voltage cable, a termination device through which the high voltage cable passes, a ground screen connected to the high voltage cable, and an apparatus as described above, wherein the apparatus is coupled to the high voltage cable so that the compartment is between a base of the termination device and the ground screen.

The assembly may comprise the system described in relation to the second aspect.

According to a fourth aspect, there is provided a method for enabling space charge distribution measurement of a high voltage cable. The method comprises: providing an apparatus described above; mounting the apparatus to the high voltage cable between a base of a termination device of the high voltage cable and a ground screen of the high voltage cable; and, while the apparatus is mounted to the high voltage cable: accessing an interior of the compartment; placing the PEA sensor in the compartment in contact with the high voltage cable; and sealing the compartment.

There may also be provided a method for enabling space charge distribution measurement of a high voltage cable comprising providing a system described above and mounting the system to the high voltage cable between a base of a termination device of the high voltage cable and a ground screen of the high voltage cable.

According to a fifth aspect, there is provided a method of maintaining a system as described above, the method comprising: accessing an interior of the compartment of the system; removing the PEA sensor from the interior of the compartment; placing the PEA sensor or a further PEA sensor in the interior of the compartment in contact with the high voltage cable; and sealing the compartment.

Accessing the interior of the compartment in any of the methods described herein may comprise removing a closure of the compartment to open the opening and thereby enable access to the interior.

Placing the PEA sensor back into the compartment may be referred to as replacing the PEA sensor. The PEA sensor may be repaired after removal and before replacement. Removing the PEA sensor of the system may comprise disconnecting one or more electrical connections between the PEA sensor and respective cable bushings. Placing the PEA sensor or a further PEA sensor into the interior of the compartment in contact with the cable may comprise connecting one or more electrical connections of the PEA sensor being placed into the compartment to respective bushing or bushings. Sealing the compartment may comprise or be preceded by placing the closure over the opening and sealing the closure to the opening to prevent water ingress.

### BRIEF DESCRIPTION OF THE DRAWINGS

The techniques will be described below with reference to the following drawings:
Fig. 1 is a cross-section of a first cable assembly
Figs. 2A to 2E show cross-sections of a second cable assembly and a process for installing a PEA sensor.
Figs. 3A and 3B show cross-sections of a third cable assembly and a process for installing a PEA sensor.
Fig. 4 shows a cross-section of a fourth cable assembly.
Fig. 5 shows a cross-section of a fifth cable assembly.

### DETAILED DESCRIPTION

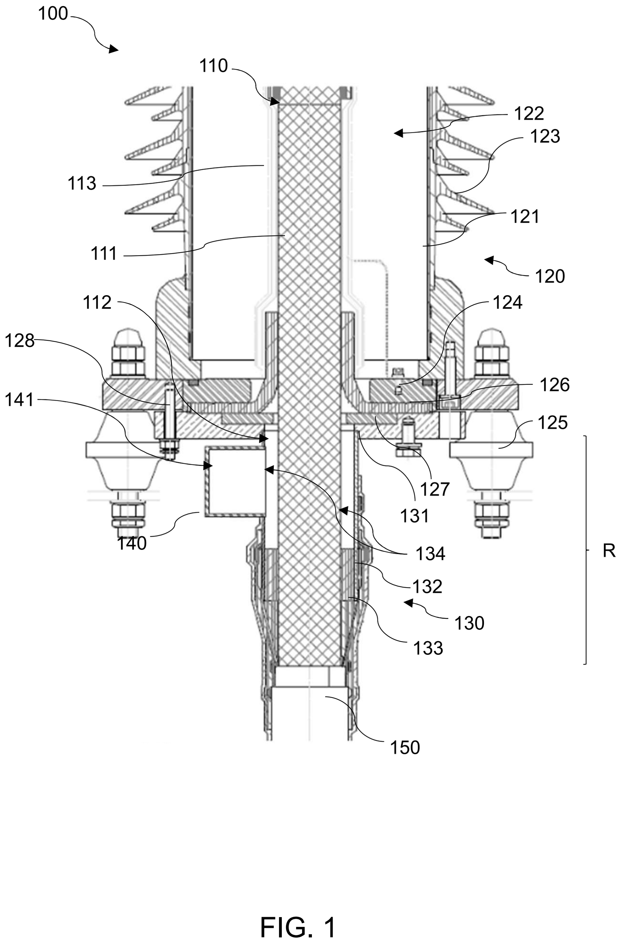

Fig. 1 shows a cross-section of a portion of a cable assembly 100. The cable assembly 100 includes a high voltage cable 110 and a termination device 120. Only part of each of the cable 110 and termination device 120 are shown in Fig. 1. The part of the termination device 120 shown in Fig. 1 is a lower part of the termination device 120, and includes a housing 121 that surrounds an interior volume 122 of the termination device 120. The interior volume 122 may be filled with a fluid, such as gas or oil. A plurality of rain sheds 123 surround the housing 121.

The cable 110 passes through the interior volume 122 of the termination device 120 and exits the termination device 120 at a base of the termination device 120. The base of the termination device is defined by a base plate 124, through which the cable 110 passes. A sleeve 126 is provided that seals against the cable 110 as it passes through the base plate 124. The sleeve 126 is supported on a ring 127. A plurality of insulators 125 are provided in contact with the base plate 124.

The cable 110 has a plurality of layers, including an outer semiconductor layer 111, shown in Fig. 1. Within the interior volume 122 of the termination device 120, further outer layers 113 are provided surrounding the cable 110 and overlapping the sleeve 126. These outer layers 113 may influence the field of the cable 110 within the termination device 120. Elsewhere along the cable 110, such as beyond a top plate of the termination device 120, the cable 110 may have other layers such as a water barrier layer. Within the termination device 120, a stress cone and other stress control layers may also be provided, although these are not shown in Fig. 1 for clarity.

Returning to what is shown in Fig. 1, where the cable 110 exits the termination device 120, it extends from the base of the termination 120 to a ground screen 150. In this region R of the cable 110, where the cable 110 extends between the base plate 124 of the termination device 120 and the ground screen 150, the outer semiconductor layer 111 is the outermost layer of the cable 110, and therefore an outer surface 112 of the cable 110 is formed by the outer semiconductor layer 111.

As outermost layer of the cable 110 is the outer semiconductor layer 111 in this region R, this provides a useful location for measuring space charge distribution of the cable 110. Specifically, this provides a useful location for performing pulsed electro-acoustic (PEA) method measurements using a PEA sensor to determine space charge distribution, because the PEA sensor can be placed in direct contact with the outer semiconductor layer 111.

To facilitate such measurements, the assembly 100 includes a compartment 140 for holding a PEA sensor (not shown in Fig. 1) in contact with the cable 110. The compartment 140 is coupled to the cable 110 between the base of the termination device 120 and the ground screen 150 by a coupling structure, which in this case is in the form of a cable gland 130.

The cable gland 130 connects to the termination device 120 at a flange 131 of the cable gland 130. The flange 131 is fixed to the base plate 124 of the termination device 120 via one or more fixings 128. A housing 132 is suspended from the flange 131. The housing 132 surrounds the cable 110 in the region R and seals against the cable 110 between the flange 131 and the ground screen 150.

Part of the housing 132 is filled with insulation 133 that surrounds the cable 110, and a part of the housing 132 above the insulation 133 and below the flange 131 defines an annular volume 134 surrounding the cable 110. The annular volume 134 provides an exposed portion of the cable 110. The compartment 140 is attached to the housing 132 of the cable gland 130 such that an interior volume 141 of the compartment 140 is open to the annular volume 134, meaning that a PEA sensor placed within the interior volume 141 can be placed into contact with the outer surface 112 of the cable 110. Accordingly, the cable gland 130, and specifically the housing 132 has an opening where the compartment 140 is attached to the housing 132. The compartment 140 has a corresponding opening, and these openings are aligned to enable access from the compartment to the annular volume.

As a result, the combination of the cable gland 130 and the compartment 140 provides an apparatus that enables PEA sensing to be performed on a cable 110 at a convenient location that avoids having to strip the cable of its water barrier layers.

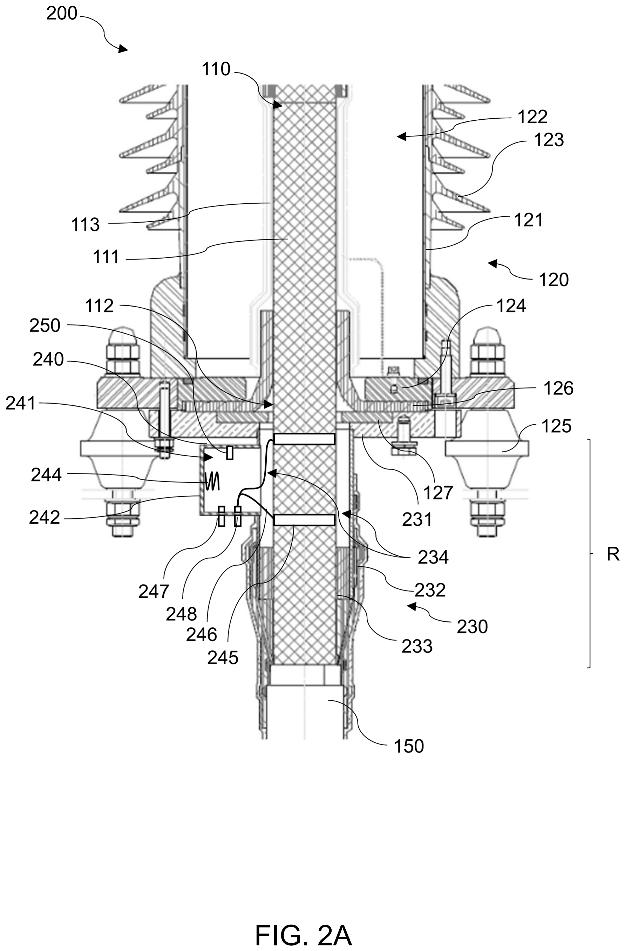

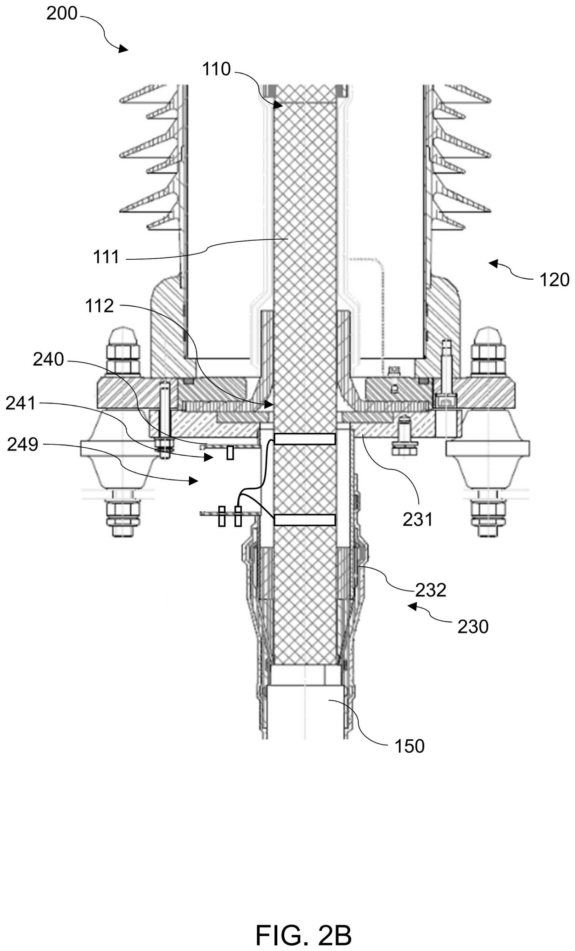

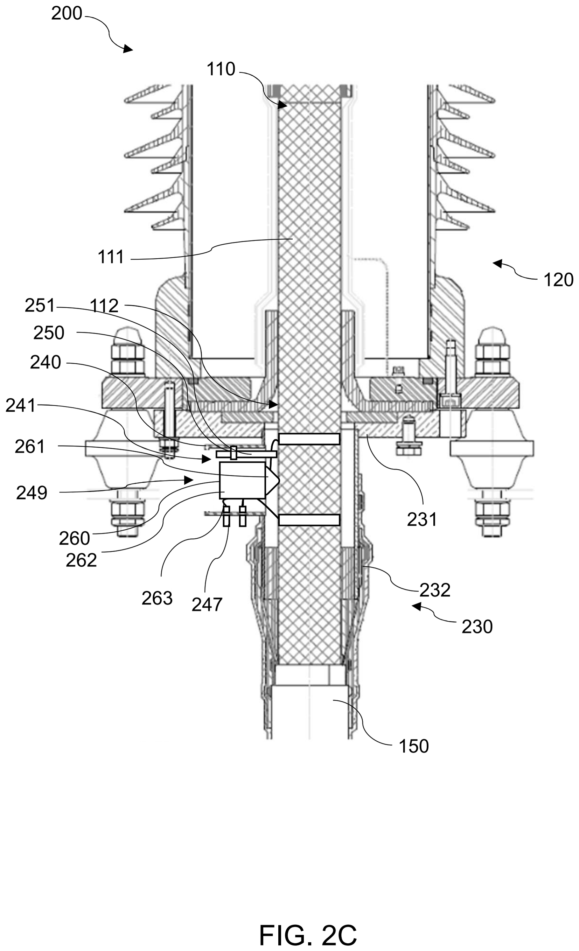

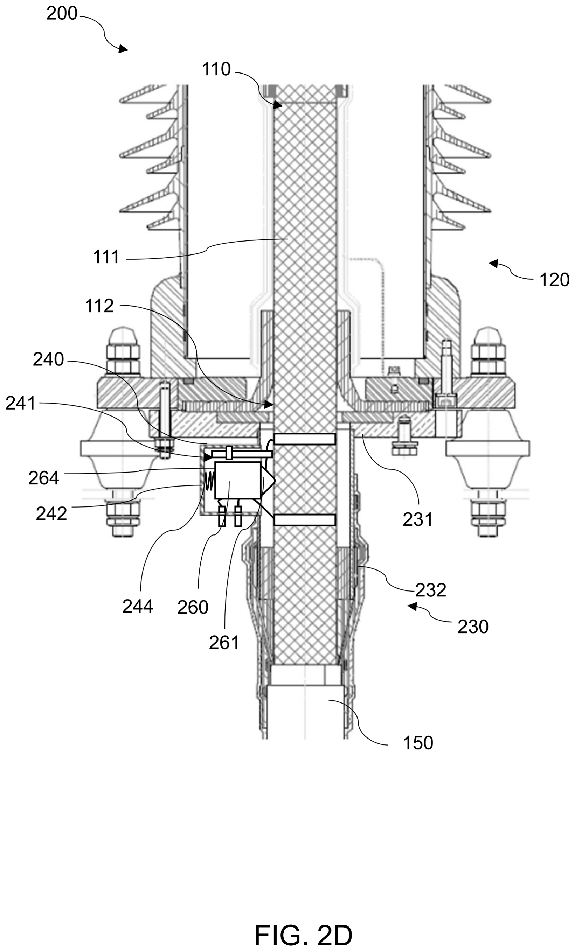

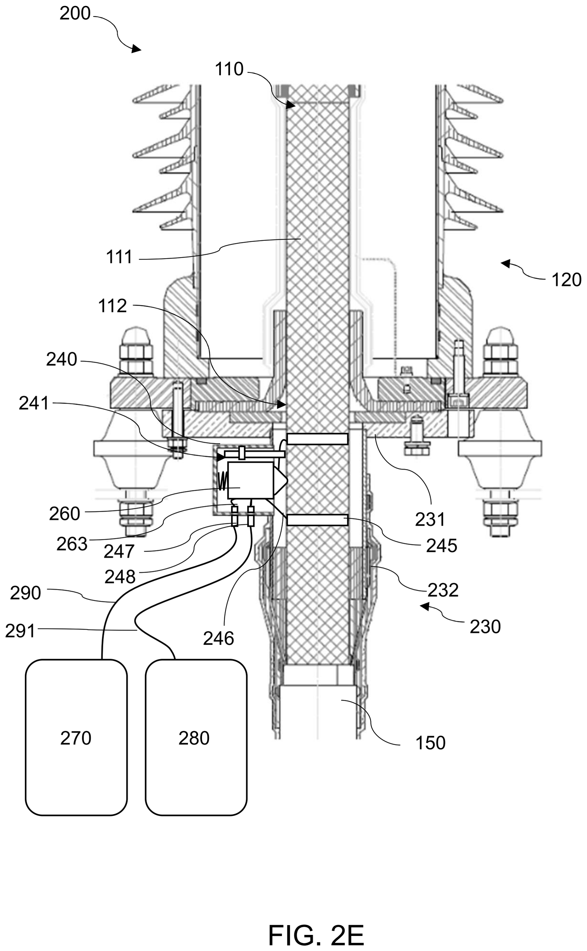

Figs. 2A to 2E show a sequence of images illustrating a method for enabling space charge distribution measurement of a high voltage cable, and particularly showing how a PEA sensor may be provided in contact with the cable 110 in the region R.. The method comprises the steps of providing an apparatus comprising a coupling structure and compartment for a PEA sensor, represented here by the cable gland 230 and compartment 240, mounting the apparatus to the high voltage cable, accessing an interior of the compartment, placing the PEA sensor in the compartment in contact with the high voltage cable and sealing the compartment. The PEA sensor can then be used to perform space charge distribution measurements. Fig. 2A represents the steps of providing and mounting the apparatus. Fig. 2B represents the step of accessing the interior of the compartment. Fig. 2C represents the step of placing the PEA sensor in the compartment in contact with the high voltage cable. Fig. 2D represents sealing the compartment. Fig. 2E represents the optional step of using the PEA sensor to perform measurements.

In each of Figs. 2A to 2E, a cable assembly 200 is shown, comprising a cable 110, a termination device 120, and a cable gland 150 having the same features as described above in relation to Fig .1.

Initially looking to Fig. 2A for explanation of the cable assembly 200, a cable gland 230 is provided that couples a compartment 240 to the cable 110 between a base of the termination and the ground screen 150. Like the cable gland 130 in Fig. 1, the cable gland 230 also includes a flange 231 by which the gland 230 connects to the termination device 120 at its base plate 124, a housing 232, and insulation 233, and defines an annular volume 234 around the cable 110 where the compartment 240 is connected to the housing 232.

This allows an interior volume 241 of the compartment 240 to be exposed to the outer surface 112 of the cable 110.

The compartment 240 has a closure 242 that closes an opening 249. The closure 242 is shown closing the opening 249 in Fig. 2A. The compartment 240 is also provided with a biasing mechanism, in the form of a spring 244 in this example, for urging the PEA sensor into contact with the cable 110 when it is provided within the compartment 240.

A pair of bushings 247, 248 are also provided for forming electrical connections through the compartment 240. One bushing 247 is for connecting the PEA sensor to an external measurement system when the PEA sensor is within the compartment 240, while the other bushing 248 is, in this example, for connecting electrodes 245 to an external pulse generator via electrical connectors 246. The electrodes 245, in use, provide electrical pulses from the pulse generator to the cable 110, which excites space charges within the cable and enables measurement of the distribution of said space charges by the PEA sensor. In other examples, pulses may be generated elsewhere in the cable, such as above the termination device by a capacitor.

The compartment 240 also includes a holder 250 for holding a thermal sensor.

Fig. 2A effectively shows the apparatus, comprising the cable gland 230 and compartment 240, having been provided and mounted to the high voltage cable between the base of the termination device 120 and the ground screen 150. The cable gland 230 and compartment 240 are mounted to the cable 110 prior to insertion of the PEA sensor into the compartment 240 because soldering or other high temperature operations may be carried out to mount the cable gland 230 to the cable 110, and such operations may interfere with or damage a PEA sensor. Therefore, the sensor is provided into the compartment after the compartment has been coupled to the cable 110. The gland 230 and the compartment 240 may be joined together prior to mounting to the cable. Alternatively, the compartment 240 and gland 230 may be mounted separately, i.e. the compartment 240 may be joined to the gland after the gland 230 has been mounted to the cable. Accordingly, the apparatus comprising the gland 230 and compartment 240 may be formed as a new apparatus for attachment during installation of the cable 110 or the compartment 240 may be retrofit to an existing cable gland 230 to form the apparatus.

Turning now to Fig. 2B, the assembly 200 is shown when the compartment 240 has been opened by removal of the closure 242. The opening 249 is therefore open to provide access to the interior 241 of the compartment.

The closure 242 may therefore be described as being removable, and may be removed by unsealing the compartment. The closure 242 may be sealed to the compartment by metal joining techniques, such as soldering or by other techniques such as using sealant and/or adhesives.

Fig. 2C shows the assembly 200 when a PEA sensor 260 and a thermal sensor 250 have been inserted into the interior 241 of the compartment 240 through the opening 249.

The thermal sensor 250 is inserted into the interior 241 of the compartment 240 and is held within the compartment 240 by the holder 251. The thermal sensor 250 is arranged to be in contact with the cable 110 in this example, as the thermal sensor 250 is a contact thermal sensor, but in other examples may be held away from the cable, such as where an optical thermal sensor is used.

The PEA sensor 260 comprises a body 262 housing a piezoelectric sensor (not visible in this figure). The piezoelectric sensor is in contact with a sensing element 261, comprising a glass pyramid for being in contact with the cable 110. Vibrations from the cable 110 are transmitted into the sensing element 261 and to the piezoelectric sensor. The vibrations cause the piezoelectric sensor to vibrate, generating an electric signal that can be transmitted to a monitoring device. In some sensors, a capacitive sensor or another sensor that is different to a piezoelectric sensor may be used to sense the vibrations.

Accordingly, the PEA sensor 260 is mounted within the compartment 240 such that it is held in contact with the cable 110, specifically an external surface 112 of the outer semiconductor layer 111 of the cable 110. The sensing element 261 of the PEA sensor 260 is held against the surface 112, to enable vibrations to be monitored. A mounting structure may be provided within the compartment 240 for holding the PEA sensor 260 in the desired position and orientation. As noted above, and also as explained below, the PEA sensor 260 may be urged against the cable 110 by a biasing mechanism, to ensure that the contact between the sensing element 261 and the cable 110 enables accurate measurements of the vibrations of the cable 110.

The PEA sensor 260 is connected to a respective bushing 247 by an electrical connection 263. The thermal sensor 250 may also be connected to a bushing by an electrical connection, although this is not shown in this figure.

Once the sensors 250, 260 have been mounted correctly within the compartment 240 and have been electrically connected to respective bushings 247, the compartment 240 may be closed and sealed. Fig. 2D shows the assembly 200 with the compartment 240 sealed by the closure 242, and with the PEA sensor 260 and thermal sensor 250 in the interior 241 of the compartment 240.

As can be seen in Fig. 2D, the closure 242 is closing the opening in the compartment, thereby sealing the cable 110 from the exterior and preventing water ingress. The closure 242 is also positioned so that the spring 244 is pressing against a rear of the PEA sensor 260, thereby urging the PEA sensor 260 towards and into contact with the cable 110. The PEA sensor 260 is therefore kept in contact with the cable 110 even when it expands or contracts due to thermal or electrical variations, by the action of the spring 244.

Once the compartment 240 is sealed, measurements of the cable 110 can be performed to determine space charge distribution within the cable 110. To perform such measurements, electrical pulses are provided in the cable 110 using the electrodes 245. To achieve this, the electrodes 245 are connected to a pulse generator 280. An electrical connection 291 connects the generator 280 to the bushing 248 which is electrically connected by the electrical connections 246 to the electrodes 245. The pulses cause vibrations of the space charges within the cable 110, which are sensed by the PEA sensor 260. Electrical readings from the PEA sensor 260 due to the vibrations are communicated to a processor 270, which may be referred to as a monitoring device or a data logger, for analysis and subsequent storage or further transmission. The electrical readings are communicated from the PEA sensor to the electrical connection 263 and then through bushing 247 to electrical connection 290, which connects to the processor 270.

The processor 270 or another processor may receive thermal measurements from the thermal sensor 250 via further electrical connections.

Figs. 2A to 2E are described here in relation to a method in which a PEA sensor is initially provided into the apparatus. Subsequently, the PEA sensor 260 may need to be removed and repaired or to be replaced. Similarly, the thermal sensor may also require replacement or removal. In these examples, the steps shown in Figs. 2B to 2E may repeated, except that the PEA sensor 260 is removed from the interior of the compartment 240 before the new PEA sensor or the same PEA sensor 260 is returned to the interior of the compartment 240.

Figs. 2A to 2E show a compartment 240 with a separate closure 242 and bushings 247, 248 on a side that is not the closure. In some examples, the closure may form part of the PEA sensor or the PEA sensor may be directly mounted to the closure. Additionally, in some examples, bushings may be provided on the closure rather than on a side of the compartment that is not the closure.

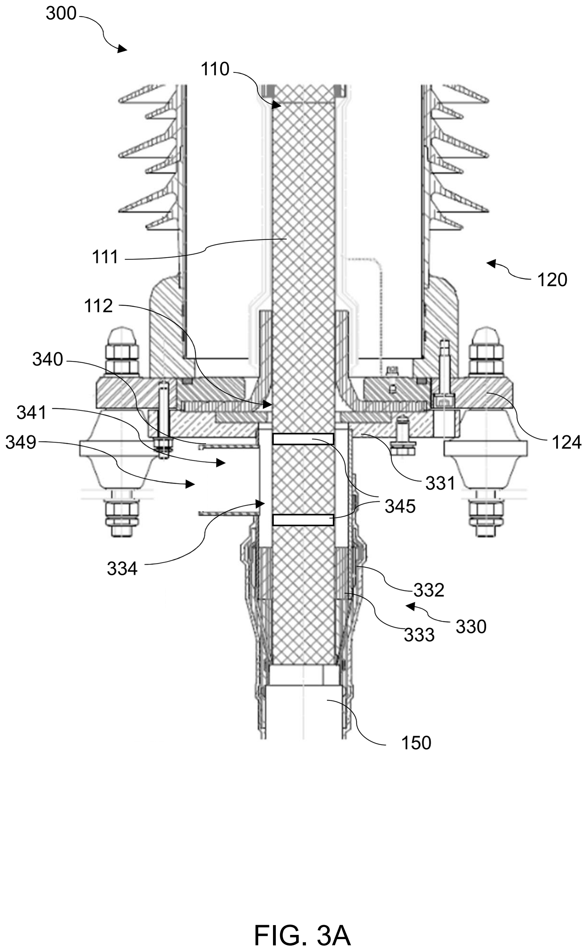

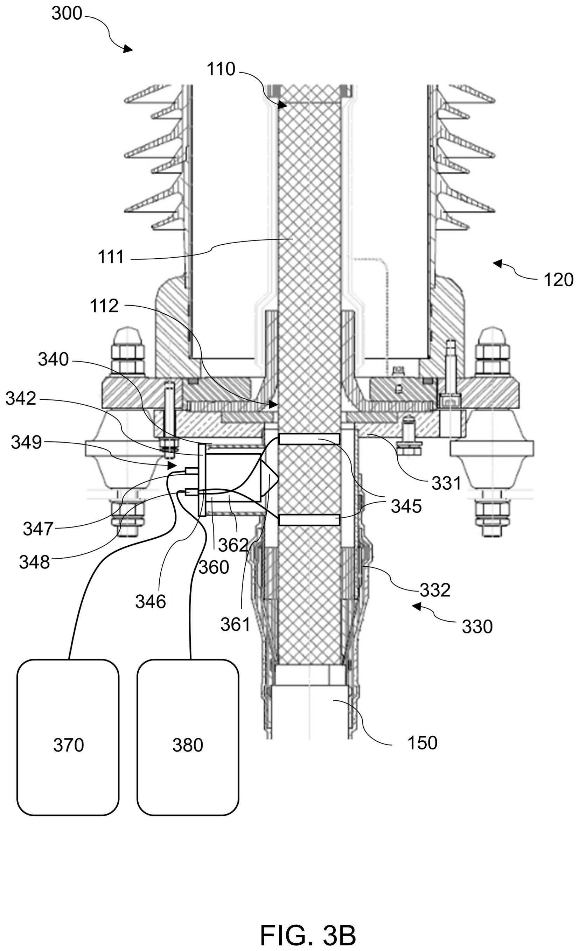

Figs. 3A and 3B show an assembly 300, which, like the assemblies 100 and 200 have a cable 110, a termination device 120, and a ground screen 150. The assembly 300 also includes a cable gland 330 and a compartment 340 arranged as described in relation to Figs. 2A to 2E above. The cable gland 330 has a flange 331 by which the gland 330 connects to the termination device 120 at its base plate 124, a housing 332, and insulation 333, and defines an annular volume 334 around the cable 110 where the compartment 340 is connected to the housing 332. This allows an interior volume 341 of the compartment 340 to be exposed to the outer surface 112 of the cable 110.

The compartment 340 is shown with its interior 341 accessible in Fig. 3A, as the opening 349 is open and without a closure.

Fig. 3B shows how a PEA sensor 360 may be provided into such a compartment 340. Specifically, the PEA sensor 360 is integrated with the closure 342. The PEA sensor 360, in the example shown, has a housing 362 having a rear surface, opposite the sensing element 361, that is formed by the closure 342. In other examples, a rear surface of the housing of the PEA sensor may instead be attached directly to the closure.

The closure 342 also includes a pair of bushings 347, 348. Electrodes 345 surrounding the cable 110 electrically connect to a pulse generator 380 via electrical connections and the bushing 348, while the PEA sensor 360 electrically connects to a processor 370 via the other bushing 347.

The closure 342 is arranged to seal the opening 349 of the compartment 340, thereby sealing the compartment 340 as a whole and sealing the PEA sensor within the compartment 340. As the PEA sensor is provided on the closure 342, the configuration and relative arrangement of the closure 342 and PEA sensor 360 result in the PEA sensor 360 being correctly oriented and positioned within the compartment 340 and in contact with the cable 110. A biasing mechanism may be provided as part of the closure or between the closure and PEA sensor, although this is not shown here.

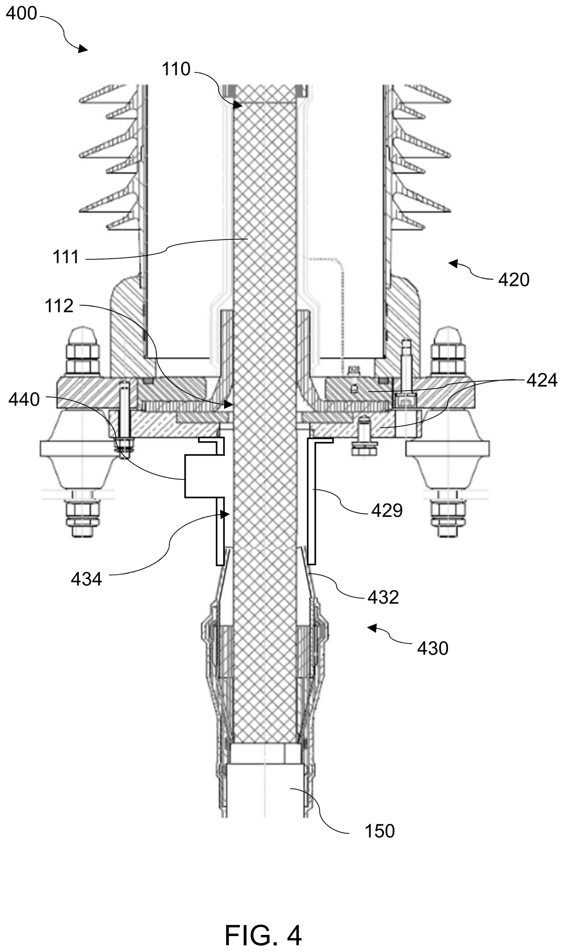

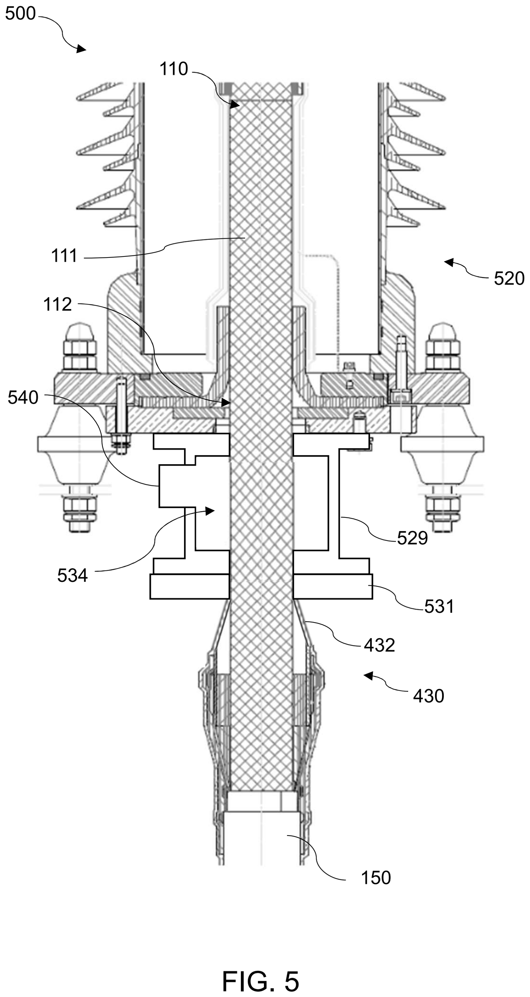

Figs. 2A to 3B show apparatus in which a compartment for receiving a PEA sensor is integrated into a coupling structure formed from a cable gland. In other examples, such as those shown in Figs. 4 and 5, the coupling structure may be a structure other than the cable gland that couples the compartment to the cable 110 between the base of the termination device and the ground screen.

Fig.4 shows an example assembly 400, in which a compartment 440 is coupled to the high voltage cable 110 by a coupling structure that is suspended and/or forms part of a base of the termination device 420. Specifically, the compartment 440 is part of a suspension structure 429 that extends downwardly from a base plate 424 of the termination device 420. The base plate 424 in Fig. 4 comprises several parts connected together, although in other examples the base plate may be a single structure. The suspension structure 429 hangs from the base plate 424 along the cable 110 towards the ground screen 150. The suspension structure 429 extends to and overlaps a housing 432 of a cable gland 430. The cable gland 430 extends to the ground screen 150. The suspension structure 429 defines an annular volume 434 around the cable 110 where the compartment 440 is connected to the suspension structure 429.

The compartment 440 may be accessed, a PEA sensor inserted, and sealed as described above.

Fig. 5 shows a further example assembly 500, in which a compartment 540 is coupled to the high voltage cable 110 by a coupling structure comprising a cable covering 529 positioned between the base of a termination device 520 and a cable gland 430. The cable covering 529 effectively forms a cylinder or a series of cylinders around the cable 110, providing an annular volume 534 between the cable covering 529 and the cable 110. The compartment 540 is connected to the annular volume 534, and therefore a PEA sensor placed in to the compartment can be placed into contact with the cable 110 at its outer surface 112. An optional insulating element 531 is provided around the cable 110 between the cable clamp 430 and the cable covering 529. The insulating element 531 may insulate the cable gland 430 from the cable covering 529.

Although described as a covering, the element 529 may also be a cable clamp. The cable covering or clamp 529 is here depicted as being between the cable gland and the base of the termination device. In other examples, it may be positioned between the cable gland and the ground screen 150.

## Claims

1. Apparatus for enabling space charge distribution measurement of a high voltage cable (110), the apparatus comprising:
a compartment (140; 240; 340; 440) for holding a pulsed electro-acoustic, PEA, sensor (260; 360) in contact with the high voltage cable; and
a coupling structure (130; 230; 330; 424; 529) configured to couple the compartment to the high voltage cable between a base of a termination device (120; 420) of the high voltage cable and a ground screen (150; 450) of the high voltage cable.

2. The apparatus of claim 1, wherein the coupling structure comprises a cable gland (130; 230; 330).

3. The apparatus of claim 1, wherein the coupling structure comprises a base plate (424) of the termination device.

4. The apparatus of claim 1, wherein the coupling structure comprises a cable clamp or a cable covering (529).

5. The apparatus of any preceding claim, wherein an interior (241; 341) of the compartment is accessible from an exterior of the compartment without removal of the coupling structure from the high voltage cable.

6. The apparatus of claim 5, wherein the compartment has an opening (349) through which the PEA sensor is received, in use, and a closure (342) for closing the opening, wherein the closure is configured to connect to or form part of the PEA sensor (360).

7. The apparatus of any preceding claim, wherein the compartment comprises a spring (244) for holding the PEA sensor in contact with the high voltage cable.

8. The apparatus of any preceding claim, wherein the compartment comprises at least one cable bushing (247, 248; 347, 348) that extends through a wall of the compartment.

9. The apparatus of any preceding claim, comprising a holder (550) for holding a thermal sensor (251), wherein the coupling structure is further configured to couple the holder to the high voltage cable between the base of the termination device and the ground screen.

10. A system comprising the apparatus of any preceding claim and a PEA sensor housed within the compartment of the apparatus.

11. The system of claim 10, further comprising a thermal sensor for measuring a temperature of the high voltage cable between the base of the termination device and the ground screen.

12. The system of claim 10 or claim 11, further comprising one or more electrodes for delivering an electrical pulse to the high voltage cable.

13. An assembly comprising a high-voltage cable, a termination device through which the high voltage cable passes, a ground screen connected to the high voltage cable, and the apparatus of any of claims 1 to 9, wherein the apparatus is coupled to the high voltage cable so that the compartment is between a base of the termination device and the ground screen.

14. A method for enabling space charge distribution measurement of a high voltage cable, the method comprising:
providing the apparatus of any of claims 1 to 9;
mounting the apparatus to the high voltage cable between a base of a termination device of the high voltage cable and a ground screen of the high voltage cable; and, while the apparatus is mounted to the high voltage cable:
accessing an interior of the compartment;
placing the PEA sensor in the compartment in contact with the high voltage cable; and
sealing the compartment.

15. A method of maintaining the system of any of claims 10 to 12, the method comprising:
accessing an interior of the compartment of the system;
removing the PEA sensor from the interior of the compartment;
placing the PEA sensor or a further PEA sensor in the interior of the compartment in contact with the high voltage cable; and
sealing the compartment.
